# EUROPEAN PATENT APPLICATION

(11) **EP 4 597 555 A1**
(43) Date of publication of application: **06.08.2025**
(21) Application number: 25150413.0
(22) Date of filing: 07.01.2025
(51) Int. Cl.: H01L 21/67

(54) **WAFER SENSOR AND WAFER ALIGNMENT SYSTEM INCLUDING THE SAME**

(30) Priority: 16.01.2024 KR 20240006758
(71) Applicant: Samsung Electronics Co., Ltd., Suwon-si, Gyeonggi-do 16677 (KR)
(72) Inventor: PARK, Junghyun, 16678 Suwon-si (KR); LEE, Minkyung, 16678 Suwon-si (KR); PARK, Sangyun, 16678 Suwon-si (KR); KO, Byunghoon, 16678 Suwon-si (KR)
(74) Representative: Elkington and Fife LLP

(57) **Abstract**

A wafer sensor includes a wafer substrate and a plurality of pixels on the wafer substrate, where each pixel of the plurality of pixels includes a blocking layer, a reflective layer on the blocking layer, a phase change material layer on the reflective layer, and a plurality of metal antennas on the phase change material layer.

## Description

### FIELD OF THE INVENTION

The disclosure relates to a wafer sensor and a wafer alignment system including the same.

### BACKGROUND OF THE INVENTION

Semiconductor substrate processing may be performed by providing devices, conductors, and insulators on wafers in a number of sequential processes. A semiconductor manufacturing process may include operations such as a photolithography process, a wafer probe, a wafer test, wafer mounting, and dicing. Each operation requires precise alignment of a substrate to the manufacturing equipment. Poor alignment may lead to deterioration in yield. That is, alignment may deteriorate due to accumulation of mechanical errors over time, thus making it necessary to properly evaluate the alignment and control a substrate transfer system to adjust alignment.

### SUMMARY OF THE INVENTION

Provided are a wafer sensor including a phase change material layer and a wafer alignment system including the same.

Additional aspects will be set forth in part in the description which follows and, in part, will be apparent from the description, or may be learned by practice of the presented embodiments of the disclosure.

According to an aspect of the disclosure, a wafer sensor may include a wafer substrate and a plurality of pixels on the wafer substrate, where each pixel of the plurality of pixels may include a blocking layer, a reflective layer on the blocking layer, a phase change material layer on the reflective layer, and a plurality of metal antennas on the phase change material layer.

The wafer sensor may include a trench between two adjacent pixels of the plurality of pixels.

The phase change material layer of each pixel of the plurality of pixels may include Sb₂Se₃, Sb₂S₃, GeSbTe, or GeSbSeTe.

The reflective layer of each pixel of the plurality of pixels may include aluminum, tungsten, or copper.

Each metal antenna of the plurality of metal antennas of each pixel of the plurality of pixels may include aluminum, tungsten, or copper.

Each pixel of the plurality of pixels may include a first spacer between the reflective layer and the phase change material layer and a second spacer between the phase change material layer and at least one metal antenna of the plurality of metal antennas.

The first spacer and the second spacer of each pixel of the plurality of pixels may include silicon oxide.

Each pixel of the plurality of pixels may include a passivation layer covering the plurality of metal antennas.

According to an aspect of the disclosure, a wafer alignment system may include a wafer sensor, a chuck configured to support the wafer sensor and heat the wafer sensor, and a transfer device configured to transfer the wafer sensor to the chuck, where the wafer sensor may include a wafer substrate, and a plurality of pixels on the wafer substrate, and where each pixel of the plurality of pixels may include a blocking layer, a reflective layer on the blocking layer, a phase change material layer on the reflective layer, and a plurality of metal antennas on the phase change material layer.

The wafer sensor may include a trench between two adjacent pixels of the plurality of pixels.

The phase change material layer of each pixel of the plurality of pixels may include Sb₂Se₃, Sb₂S₃, GeSbTe, or GeSbSeTe.

The reflective layer of each pixel of the plurality of pixels may include aluminum, tungsten, or copper.

Each metal antenna of the plurality of metal antennas of each pixel of the plurality of pixels may include aluminum, tungsten, or copper.

Each pixel of the plurality of pixels may include a first spacer between the reflective layer and the phase change material layer and a second spacer between the phase change material layer and at least one metal antenna of the plurality of metal antennas.

The wafer alignment system may include a measurement station configured to measure a change in the phase change material layer of at least one pixel of the plurality of pixels and control the transfer device to adjust alignment based on the measured change.

The measurement station may be further configured to measure a change in partial reflectivity of the phase change material layer of the at least one pixel of the plurality of pixels.

The measurement station may be further configured to initialize a measurement history of the wafer sensor by causing a uniform phase change in the phase change material layer of the at least one pixel of the plurality of pixels.

According to an aspect of the disclosure, a wafer alignment method may include loading a wafer sensor on a chuck, the wafer sensor including a wafer substrate and at least one pixel including a blocking layer, a reflective layer on the blocking layer, a phase change material layer on the reflective layer, and a plurality of metal antennas on the phase change material layer, heating, by the chuck, at least a portion of the phase change material layer to a crystallization temperature or greater, unloading the wafer sensor from the chuck, analyzing, by a measurement station, a change in the phase change material layer, and controlling, by the measurement station, the transfer device to adjust alignment of the wafer sensor based on the analyzed change.

The analyzing of the change in the phase change material layer may include measuring a change in reflectivity of the phase change material layer, and determining an alignment of the wafer sensor based on the measured change in reflectivity.

The method may include, after the analyzing of the change in the phase change material layer, initializing a measurement history of the wafer sensor by uniformly forming a phase change in the phase change material layer.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a cross-sectional view illustrating a wafer sensor according to one or more embodiments;
FIG. 2 is a flowchart illustrating a wafer alignment method according to one or more embodiments;
FIGS. 3 to 6 are cross-sectional views illustrating a wafer alignment method according to one or more embodiments;
FIG. 7 is a block diagram illustrating a wafer alignment system according to one or more embodiments;
FIGS. 8 to 10 are graphs illustrating a difference in reflectivity according to wavelength of a phase change material layer of a wafer sensor according to one or more embodiments;
FIG. 11 is a diagram illustrating a thermal analysis simulation result according to one or more embodiments;
FIG. 12 is a graph illustrating a temperature change over time of a wafer sensor according to one or more embodiments; and
FIG. 13 is a diagram illustrating a temperature change applied for controlling a phase of a phase change material according to one or more embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, example embodiments will be described in detail with reference to the accompanying drawings. In the following drawings, the same reference numerals refer to the same components, and the size of each component in the drawings may be exaggerated for clarity and convenience of description. In addition, embodiments described below are merely illustrative, and various modifications are possible from these embodiments.

In the following description, when a component is referred to as being "above" or "on" another component, it may be directly on an upper, lower, left, or right side of the other component while making contact with the other component or may be above an upper, lower, left, or right side of the other component without making contact with the other component.

The terms of a singular form may include plural forms unless otherwise specified. Terms such as first, second, etc. may be used to describe various components, but are used only for the purpose of distinguishing one component from another component. These terms do not limit the difference in the material or structure of the components.

In addition, when a certain part "includes" a certain component, it means that other components may be further included rather than excluding other components unless otherwise stated.

The use of the term "the" and similar designating terms may correspond to both the singular and the plural.

Operations of a method may be performed in an appropriate order unless explicitly described in terms of order. In addition, the use of all illustrative terms (e.g., etc.) is merely for describing technical ideas in detail, and the scope is not limited by these examples or illustrative terms unless limited by the claims.

In addition, terms such as "unit" and "module" described in the specification may indicate a unit that processes at least one function or operation, and this may be implemented as hardware or software, or may be implemented as a combination of hardware and software.

The connection or connection members of lines between the components shown in the drawings exemplarily represent functional connection and/or physical or circuit connections, and may be replaceable or represented as various additional functional connections, physical connections, or circuit connections in an actual device.

The use of all examples or illustrative terms is simply to describe technical ideas in detail, and the scope is not limited due to these examples or illustrative terms unless the scope is limited by the claims.

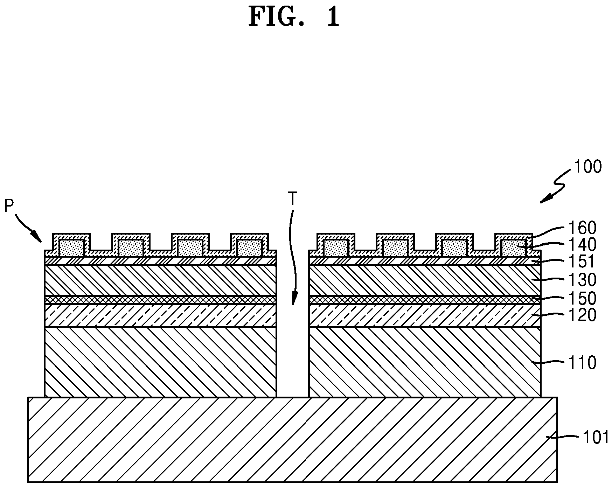

FIG. 1 is a cross-sectional view illustrating a wafer sensor according to one or more embodiments.

Referring to FIG. 1, a wafer sensor 100 may include a wafer substrate 101 and a plurality of pixels P provided on the wafer substrate 101. Each of the plurality of pixels P may include a blocking layer 110, a reflective layer 120 provided on the blocking layer 110, a phase change material layer 130 provided on the reflective layer 120, and a plurality of metal antennas 140 provided on the phase change material layer 130.

The wafer substrate 101 may have a wafer shape. The wafer substrate 101 may be formed in a size and shape corresponding to a wafer. The wafer substrate 101 may have a circular plate shape. The wafer substrate 101 may include a material having a low heat transfer coefficient to minimize a phenomenon in which a transfer pattern spreads due to a heat transfer. The wafer substrate 101 may include, for example, a silicon wafer.

The wafer sensor 100 may include the plurality of pixels P. Although FIG. 1 shows that the wafer sensor 100 includes two pixels P, the wafer sensor 100 is not limited thereto, and may include fewer or more pixels P. The separation between the pixels P may be, for example, about 100 nm to about 100 µm.

The blocking layer 110 may be provided on the wafer substrate 101. The blocking layer 110 may block heat transfer from one pixel P to adjacent pixel P. The blocking layer 110 may have a sufficient thickness for blocking heat transfer from one pixel P to the adjacent pixel P. A thickness of the blocking layer 110 may be, for example, about 500 nm or more. The blocking layer 110 may include silicon oxide.

The reflective layer 120 provided on the blocking layer 110 may reflect light. The reflective layer 120 may resonate the light by reflecting the light together with the metal antennas 140 to be described later. For example, a thickness of the reflective layer 120 may be about 10 nm to about 200 nm.

The reflective layer 120 may include a metal that is compatible with a complementary metal-oxide-semiconductor (CMOS) technology used in semiconductor manufacturing. The reflective layer 120 may include, for example, aluminum, tungsten, or copper.

Optical properties of the phase change material layer 130 may be changed according to a phase change. The phase change material layer 130 may have an optical refractive index that changes according to a phase change. The phase change material layer 130 may include a phase change material that reversibly changes between an amorphous state and a crystalline state depending on a heating time.

The phase change material layer 130 may include a material having a lower width variation of a refractive index imaginary component and a higher width variation of a refractive index real component in an operating wavelength band. The phase change material layer 130 may include Sb₂Se₃, Sb₂S₃, GeSbTe, or GeSbSeTe. However, the phase change material layer 130 is not limited thereto, and the phase change material layer 130 may include materials representing a phase change due to heat. The phase change material layer 130 may include, for example, a chalcogenide material including elements selected from silicon (Si), germanium (Ge), antimony (Sb), tellurium (Te), bismuth (Bi), indium (In), tin (Sn), and selenium (Se). Each element constituting the chalcogenide material may have various chemical composition ratios. The phase change rate according to the crystallization temperature, melting point, and crystallization energy of the phase change material constituting the phase change material layer 130 may be adjusted based on the chemical composition ratios of the elements. For example, the thickness of the phase change material layer 130 may be about 5 nm to about 500 nm.

The pixel P may include a plurality of metal antennas 140. Since the plurality of metal antennas 140 are provided on the reflective layer 120, the plurality of metal antennas 140 may resonate the light by reflecting the reflective layer 120. Although FIG. 1 shows that the pixel P includes four metal antennas 140, the pixel P is not limited thereto, and the pixel P may include fewer or more metal antennas 140.

The metal antennas 140 may include a metal that is compatible with a CMOS technology used in semiconductor manufacturing. The metal antennas 140 may include, for example, aluminum, tungsten, or copper. The separation distance between the plurality of metal antennas 140 may be, for example, at least 100 nm and 10 times or less of the wavelength of light operating. The width of each of the metal antennas 140 may be about 0.1 to about 0.9 times the separation distance between the metal antennas 140.

The metal antenna 140 may have a one-dimensional grating structure, and as a two-dimensional array, may have a structure such as square, rectangle, circle, and ellipsoid.

A trench T may be formed between the plurality of pixels P. That is, a trench T may be formed between adjacent pixels of the plurality of pixels P, such that the form/array of the pixels P may be a result of the trenches T. The trench T may have a sufficient width for blocking heat transfer from one pixel P to an adjacent pixel P. The width of the trench T may be, for example, about 500 nm to about 100 µm.

A first spacer 150 may be provided between the reflective layer 120 and the phase change material layer 130, and a second spacer 151 may be provided on the phase change material layer 130. That is, the second spacer 151 may be between the phase change material layer 130 and the plurality of antennas 140. The first spacer 150 and the second spacer 151 may function as an insulating layer for passivation of the phase change material layer 130. The first spacer 150 and the second spacer 151 may include silicon oxide.

A passivation layer 160 may be provided on the plurality of metal antennas 140. The passivation layer 160 may be provided to cover the plurality of metal antennas 140. That is, the passivation layer 160 may cover top surfaces and side surfaces of the plurality of metal antennas 140. The passivation layer 160 may include, for example, aluminum oxide.

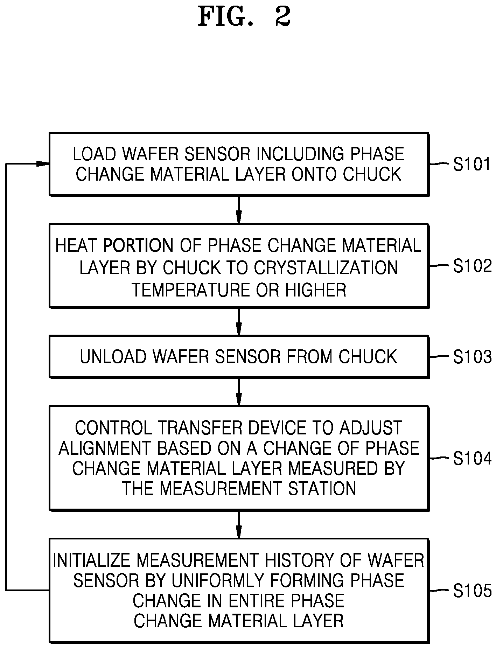

FIG. 2 is a flowchart illustrating a wafer alignment method according to one or more embodiment.

In operation S101, a wafer sensor may be loaded on a chuck by a transfer device. The wafer sensor may include a phase change material layer. When the wafer sensor is loaded onto the chuck, the chuck may absorb the wafer sensor.

In operation S102, a portion of the phase change material layer may be heated to a crystallization temperature or above a crystallization temperature by the chuck. The chuck may include a heater. When a wafer sensor including a phase change material layer contacts the chuck for a predetermined amount of time and transfers energy at or above the crystallization temperature of the phase change material layer from the chuck to the phase change material layer, phase change may occur only in the portion of the phase change material layer that contacts the chuck. That is, operation S102 may be performed to change the amorphous phase change material into a crystalline state by heating the phase change material to a temperature at or higher than the crystallization temperature. Through operation S102, the portion of the phase change material layer of the wafer sensor contacting the chuck may change to crystalline state, and the pattern of the chuck may be recorded.

In operation S103, the wafer sensor may be unloaded from the chuck by the transfer device. The wafer sensor may be unloaded from the chuck and then analyzed by a measurement station.

In operation S104, the measurement station may control the transfer device to adjust alignment based on a change in the phase change material layer measured by the measurement station. The measurement station may check the symmetry of a pattern of the chuck through the change of the phase change material layer of the wafer sensor, and may control the transfer device to adjust alignment after checking whether the wafer sensor is aligned. The measurement station may check the pattern of the chuck through a change in reflectivity of the phase change material layer of the wafer sensor. Using the pattern of the chuck, the relative positions between the wafer sensor and the chuck may be checked, and the transfer device may be controlled to adjust alignment.

In operation S105, a measurement history of the wafer sensor may be initialized by uniformly forming a phase change in the entire phase change material layer, or at least a portion of the phase change material layer. For reuse of the wafer sensor, a phase change may be uniformly formed over the entire phase change material layer. A reset operation of heating a phase change material layer in a crystalline state to a temperature higher than a melting temperature to change the phase change material layer in an amorphous state may be performed. That is, after operations S101-S104 are performed in which portions of the phase change material layer are changed from the amorphous state to the crystalline state, the measurement station may perform a reset operation to change the entire phase change material layer back to the amorphous state. Thus, the wafer sensor may be repeated used for with readjustment of alignment by the transfer device.

In addition, after loading the wafer sensor onto the chuck by the transfer device, the process described above may be repeated until the wafer sensor is aligned.

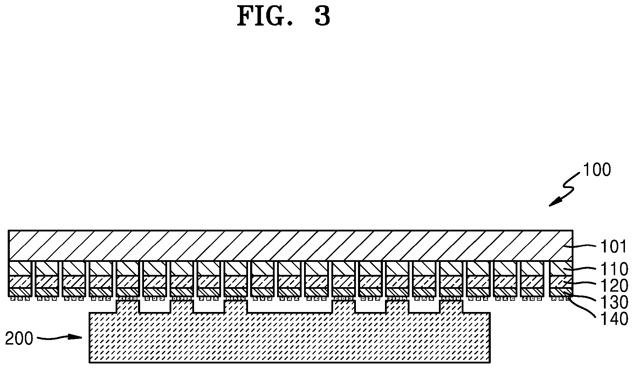

FIGS. 3 to 6 are cross-sectional views illustrating a wafer alignment method according to one or more embodiments. The wafer sensors shown in FIGS. 3 to 6 may include the same or similar aspects as the wafer sensor described in FIG. 1, and repeated descriptions may be omitted.

Referring to FIG. 3, some of the metal antennas 140 of the wafer sensor 100 may be positioned to contact the chuck 200.

The chuck 200 may be a support member configured to support the wafer sensor 100. The size of the chuck 200 (e.g., width, area, etc.) may be smaller than that of the wafer sensor 100 to be supported. However, embodiments are not limited thereto, and the shape, dimension, etc. of the chuck 200 may vary depending on the shape, dimension, etc. of the supported wafer sensor 100.

The chuck 200 may include a heater. The heater may include a conductive material capable of generating heat sufficient to change the phase of the phase change material layer 130. The heat generated by the heater of the chuck 200 may be transferred to the wafer sensor 100. The phase change material layer 130 may be heated by the chuck 200 to store pattern and edge information of the chuck 200.

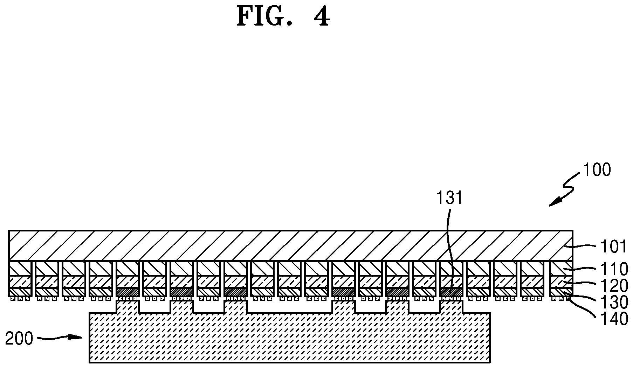

Referring to FIG. 4, the heat generated by the heater of the chuck 200 may be transferred to the wafer sensor 100. At some portions contacting the chuck 200, the phase change material layer 130 of the wafer sensor 100 may change into a crystalline phase change material layer 131 from an amorphous phase change material layer.

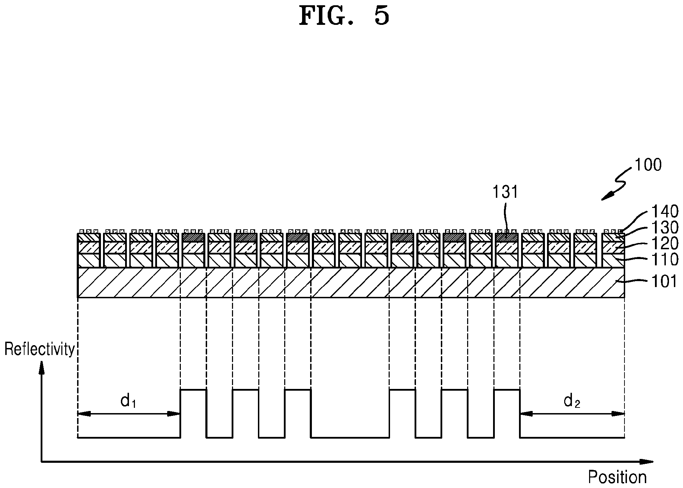

Referring to FIG. 5, the wafer sensor 100 may be unloaded from the chuck 200 and then analyzed by the measurement station. The reflectivity according to the position of the wafer sensor may be measured using light at the measurement station. The light may refer to a single wavelength and may include wavelengths such as ultraviolet rays, visible rays, and infrared rays. The measurement station may include a reflectivity measurement device.

A reflectivity map on the wafer sensor 100 may be generated by moving the wafer sensor 100 or moving the measurement station. When the amorphous phase change material layer 130 of the wafer sensor 100 changes to the crystalline phase change material layer 131, the reflectivity changes. Therefore, the reflectivity difference according to the position may appear in the reflectivity map. Since the separation distance between the metal antennas 140 may be configured to be about 1 µm or less, low reflectivity information and high reflectivity information may be obtained by matching location information with very high precision.

By comparing the distance d1 from the left edge region of the wafer sensor 100 to the pixel in which the reflectivity change occurs for the first time, and the distance d2 from the right edge region of the wafer sensor 100 to the pixel in which the reflectivity change occurs for the first time, it may be determined whether the wafer sensor 100 is aligned.

In FIG. 5, when the amorphous phase change material layer 130 changes to the crystalline phase change material layer 131, the wafer sensor 100 designed to increase the reflectivity was used. However, a wafer sensor 100 designed to reduce the reflectivity may be implemented as will be understood by one of ordinary skill in the art from the disclosure herein.

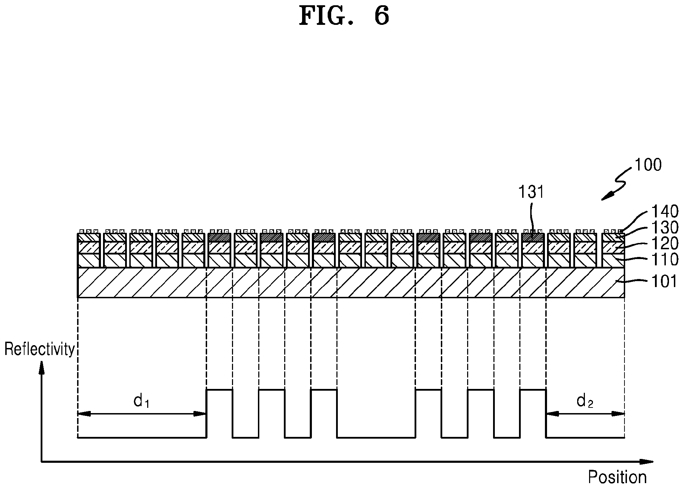

FIG. 6 illustrates a case in which the wafer sensor is not aligned.

Referring to FIG. 6, when comparing the distance d1 from the left edge region of the wafer sensor 100 to the pixel in which the reflectivity change occurs for the first time, and the distance d2 from the right edge region of the wafer sensor 100 to the pixel in which the reflectivity change occurs for the first time, a difference occurs in the values of d1 and d2. The transfer device may be controlled to adjust alignment in a direction that reduces the difference in the values of d1 and d2. The case where d1 is greater than d2 is illustrated in FIG. 6, but the same may also be true when d2 is greater than d1.

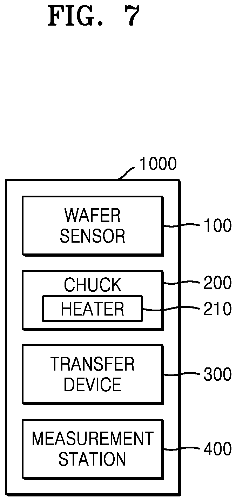

FIG. 7 is a block diagram illustrating a wafer alignment system according to one or more embodiments.

Referring to FIG. 7, a wafer alignment system 1000 may include a wafer sensor 100, a chuck 200 supporting the wafer sensor 100, a transfer device 300 for transferring the wafer sensor 100 to the chuck 200, and a measurement station 400 for controlling the transfer device 300 to adjust alignment based on analyzing the phase change material layer 130 of the wafer sensor 100.

The wafer sensors shown in FIG. 7 may include the same or similar aspects as the wafer sensor described in the figures above, and repeated descriptions may be omitted.

The chuck 200 may be a support member configured to support the wafer sensor 100. The size of the chuck 200 may be smaller than that of the wafer sensor 100 to be supported. However, embodiments are not limited thereto, and the shape, dimension, etc. of the chuck 200 may vary depending on the shape, dimension, etc. of the supported wafer sensor 100.

The chuck 200 may be an electrostatic chuck, a vacuum chuck, a pin-type chuck, a groove-type chuck, an electromagnetic chuck, or the like. For example, when the chuck 200 includes an electrostatic chuck, a voltage may be applied to an electrode included in the chuck 200 to induce charges of opposite polarities to the wafer sensor 100 and the chuck 200, thereby fixing the wafer sensor 100. For example, when the chuck 200 includes a vacuum chuck, the chuck 200 may suck air from a vacuum hole placed on one surface of the chuck 200 to generate suction force, the wafer sensor 100 may be fixed.

The chuck 200 may include a heater 210. The heater 210 may include a conductive material capable of generating heat sufficient to change the phase of the phase change material layer 130 of the wafer sensor 100. The chuck may be heated by the heater 210, and the heat of the heated chuck may be transferred to the wafer sensor 100. The phase change material layer 130 of the wafer sensor 100 may be heated by the chuck 200 to store a pattern of the chuck 200.

The transfer device 300 may transfer the wafer sensor 100. The transfer device 300 may be used to load the wafer sensor 100 on the chuck 200. The transfer device 300 may be used to unload the wafer sensor 100 from the chuck 200. The transfer device 300 may perform ascending and descending operations to perform a process of loading and unloading the wafer sensor 100 with respect to the chuck 200. The transfer device 300 may include, for example, a transfer robot.

The measurement station 400 may obtain information stored in the phase change material by measuring a change in optical properties of the phase change material layer 130 of the wafer sensor 100. The measurement station 400 may obtain information stored in the phase change material by measuring a change in reflectivity of the phase change material layer 130 of the wafer sensor 100.

Pattern information of the chuck 200, which may be stored in the phase change material layer 130, may be transmitted to the measurement station 400. The measurement station 400 may be electrically connected to the transfer device 300, and the measurement station 400 may control the transfer device 300 to adjust alignment based on the pattern of the chuck 200, which may be stored in the phase change material layer 130 of the wafer sensor 100.

The measurement station 400 may uniformly cause a phase change in the entire phase change material layer 130 of the wafer sensor 100 (or in at least a portion of the phase change material layer 130). The measurement station 400 may perform a reset operation by heating the phase change material layer 130 of the wafer sensor 100 to a temperature at or higher than the melting temperature. Accordingly, the wafer sensor 100 may be repeatedly used based on control of the transfer device 300, by the measurement station 400, for adjustment of alignment.

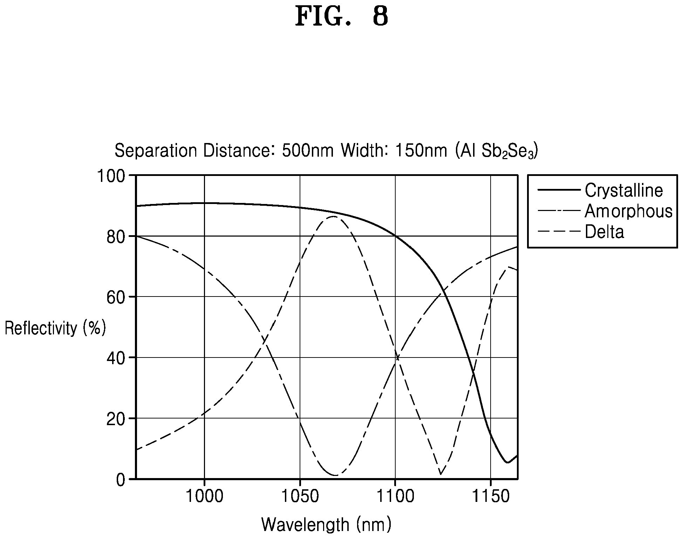

FIGS. 8 to 10 are graphs illustrating a difference in reflectivity according to wavelengths of a phase change material layer of a wafer sensor according to one or more embodiments.

In FIG. 8, reflectivity was measured using a wafer sensor including aluminum as a metal antenna and a reflective layer and Sb₂Se₃ as a phase change material layer. The thickness of the blocking layer is about 5 µm, the thickness of the reflective layer is about 50 nm, the thicknesses of the first spacer and the second spacer are about 10 nm, the thickness of the phase change material layer is about 60 nm, the thickness of each of the metal antennas is about 50 nm, and the thickness of the passivation layer is about 10 nm. The separation distance between the metal antennas is about 500 nm, and the width of each of the metal antennas is about 150 nm.

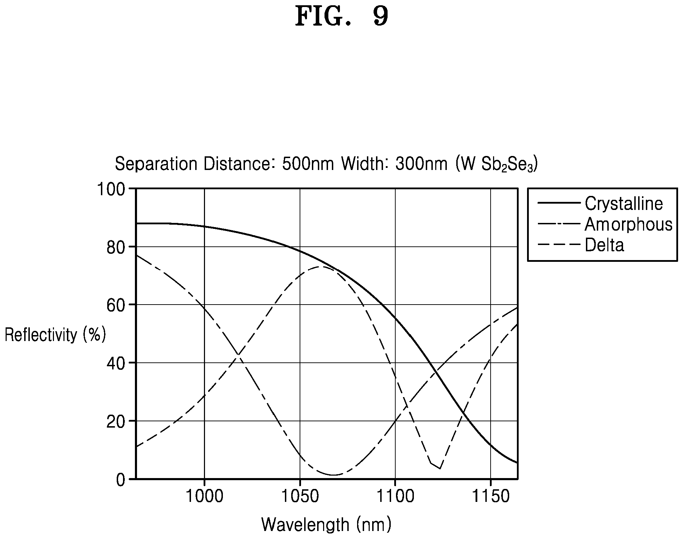

In FIG. 9, reflectivity was measured using a wafer sensor including tungsten as metal antennas and a reflective layer and Sb₂Se₃ as a phase change material layer. The thickness of the blocking layer is about 5 µm, the thickness of the reflective layer is about 50 nm, the thicknesses of the first spacer and the second spacer are about 10 nm, the thickness of the phase change material layer is about 60 nm, the thickness of each of the metal antennas is about 50 nm, and the thickness of the passivation layer is about 10 nm. The separation distance between the metal antennas is about 500 nm, and the width of each of the metal antennas is about 300 nm.

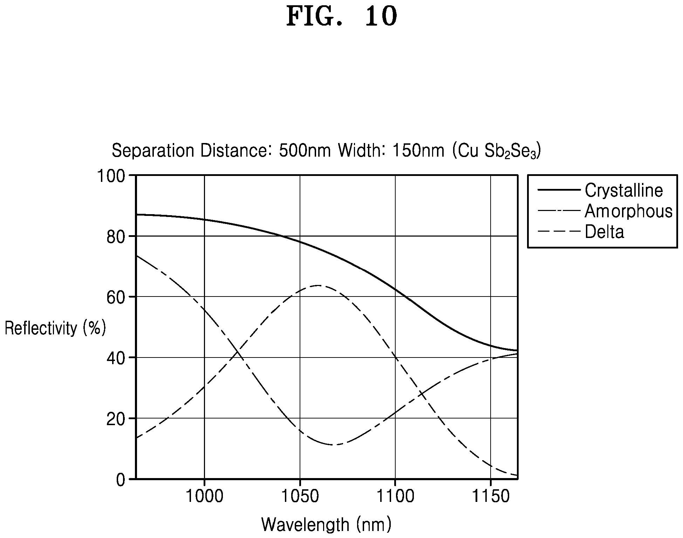

In FIG. 10, reflectivity was measured using a wafer sensor including copper as metal antennas and a reflective layer and Sb₂Se₃ as a phase change material layer. The thickness of the blocking layer is about 5 µm, the thickness of the reflective layer is about 50 nm, the thicknesses of the first spacer and the second spacer are about 10 nm, the thickness of the phase change material layer is about 60 nm, the thickness of each of the metal antennas is about 50 nm, and the thickness of the passivation layer is about 10 nm. The separation distance between the metal antennas is about 500 nm, and the width of each of the metal antennas is about 150 nm.

Referring to FIGS. 8 to 10, in a crystalline state, since the real component of the refractive index increases in the infrared band, the resonance wavelength redshifts and the resonance wavelength increases. As a result, it may be seen that the resonance wavelength has changed to a long wavelength region in a crystalline state compared to an amorphous state.

Delta represents the absolute value of the difference between reflectivities of crystalline and amorphous states. This shows the signal magnitude of the difference between reflectivities of the vertical axes of FIGS. 5 and 6. It may be seen that the wafer sensor has a resonance structure including metal antennas and a reflective layer, and thus the signal magnitude may be amplified.

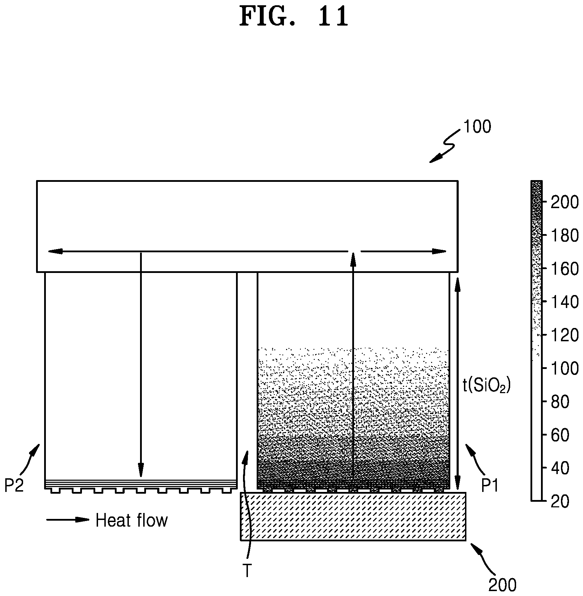

FIG. 11 is a diagram illustrating a thermal analysis simulation result according to one or more embodiments.

Referring to FIG. 11, a first pixel P1 of the wafer sensor 100 contacting the chuck 200 is heated. The first pixel P1 and a second pixel P2 are spaced apart from each other and are separated by a trench T.

The temperature of the chuck 200 is about 210 °C, thermal energy is continuously supplied to the chuck, and the result of the transient thermal simulation according to the time when the first pixel P1 touches the chuck 200 is shown in FIG. 11. In the shaded distribution, the darkest region represents a temperature of about 210 °C.

Heat may not be transferred through the trench T, and it may be seen that heat is transferred to the second pixel P2 through the wafer substrate. Even if the first pixel P1 is heated by the chuck 200, it may be confirmed that the temperature of the second pixel P2 does not increase.

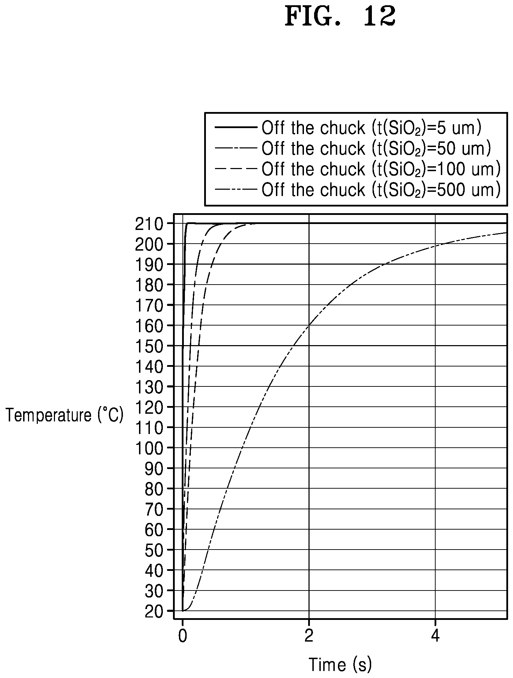

FIG. 12 is a graph illustrating a temperature change over time of a wafer sensor according to one or more embodiments.

Referring to FIG. 12, the temperature change of the second pixel P2 according to the thickness t(SiO₂) of the blocking layer of FIG. 11 may be seen. The first pixel P1 of the wafer sensor 100 contacting the chuck 200 is heated, and the second pixel P2 not contacting the chuck 200 is not heated.

When the thickness t(SiO₂) of the blocking layer is 5 µm, 50 µm, or 100 µm, it may be seen that the temperature of the second pixel P2 not contacting the chuck 200 rapidly increases to about 210 °C.

On the other hand, when the thickness of the blocking layer (t(SiO₂)) is about 500 µm, it may be confirmed that even if the wafer sensor 100 stays on the chuck 200 for about 1 second to about 2 seconds, the temperature of the wafer sensor 100 does not rise to about 210 °C required for amorphization.

Accordingly, it may be seen that when the blocking layer has a sufficient thickness, the blocking layer may serve to block heat transfer to an adjacent pixel.

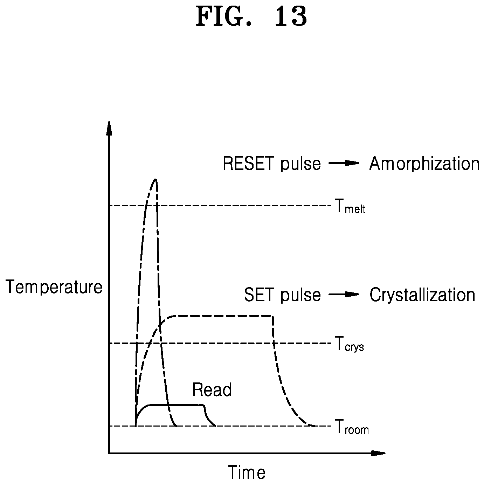

FIG. 13 is a diagram illustrating a temperature change applied for controlling a phase of a phase change material according to one or more embodiments.

Referring to FIG. 13, the phase of the phase change material may be changed by applying a predetermined temperature to the phase change material and heating the phase change material to a temperature at or higher than a phase change temperature (crystallization temperature or melting temperature). In a set operation using a crystallization method, a phase change material in an amorphous state may be heated to a temperature at or higher than a crystallization temperature to be converted into the phase change material in a crystalline state. In addition, in a reset operation using an amorphization method, the crystalline phase change material may be converted into an amorphous phase change material by heating the crystalline phase change material to a temperature higher than the melting temperature.

The wafer sensor and the wafer alignment system including the same according to one or more embodiments may have high signal sensitivity by maximizing a difference in reflectivities at a light source wavelength detected using a resonance structure.

According to one or more embodiments, a wafer sensor capable of detecting a change in a phase change material layer at a non-contact high speed through optical reflectivity measurement and a wafer alignment system including the same may be provided.

According to one or more embodiments, a wafer sensor with high signal sensitivity and a wafer alignment system including the same may be provided by maximizing a difference in reflectivities at a light source wavelength detected using a resonance structure.

According to one or more embodiments, a wafer sensor and a wafer alignment system including the same, capable of securing a high spatial resolution through a heat shielding structure between a plurality of pixels, may be provided..

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A wafer sensor comprising:
a wafer substrate; and
a plurality of pixels on the wafer substrate,
wherein each pixel of the plurality of pixels comprises:
a blocking layer,
a reflective layer on the blocking layer,
a phase change material layer on the reflective layer, and
a plurality of metal antennas on the phase change material layer.

2. The wafer sensor of claim 1, further comprising a trench between two adjacent pixels of the plurality of pixels.

3. The wafer sensor of claim 1 or 2, wherein the phase change material layer of each pixel of the plurality of pixels comprises Sb₂Se₃, Sb₂S₃, GeSbTe, or GeSbSeTe.

4. The wafer sensor of any preceding claim, wherein the reflective layer of each pixel of the plurality of pixels comprises aluminum, tungsten, or copper.

5. The wafer sensor of any preceding claim, wherein each metal antenna of the plurality of metal antennas of each pixel of the plurality of pixels comprises aluminum, tungsten, or copper.

6. The wafer sensor of any preceding claim, wherein each pixel of the plurality of pixels further comprises:
a first spacer between the reflective layer and the phase change material layer; and
a second spacer between the phase change material layer and at least one metal antenna of the plurality of metal antennas.

7. The wafer sensor of claim 6, wherein the first spacer and the second spacer of each pixel of the plurality of pixels comprise silicon oxide.

8. The wafer sensor of any preceding claim, wherein each pixel of the plurality of pixels further comprises a passivation layer covering the plurality of metal antennas.

9. A wafer alignment system comprising:
a wafer sensor according to any preceding claim;
a chuck configured to support the wafer sensor and heat the wafer sensor; and
a transfer device configured to transfer the wafer sensor to the chuck.

10. The wafer alignment system of claim 9, further comprising a measurement station configured to:
measure a change in the phase change material layer of at least one pixel of the plurality of pixels; and
control the transfer device to adjust alignment based on the measured change.

11. The wafer alignment system of claim 10, wherein the measurement station is further configured to measure a change in partial reflectivity of the phase change material layer of the at least one pixel of the plurality of pixels.

12. The wafer alignment system of claim 10 or 11, wherein the measurement station is further configured to initialize a measurement history of the wafer sensor by causing a uniform phase change in the phase change material layer of the at least one pixel of the plurality of pixels.

13. A wafer alignment method comprising:
loading a wafer sensor on a chuck, the wafer sensor comprising:
a wafer substrate; and
at least one pixel comprising a blocking layer, a reflective layer on the blocking layer, a phase change material layer on the reflective layer, and a plurality of metal antennas on the phase change material layer;
heating, by the chuck, at least a portion of the phase change material layer to a crystallization temperature or greater;
unloading the wafer sensor from the chuck;
analyzing, by a measurement station, a change in the phase change material layer; and
controlling, by the measurement station, the transfer device to adjust alignment of the wafer sensor based on the analyzed change.

14. The wafer alignment method of claim 13, wherein the analyzing of the change in the phase change material layer comprises:
measuring a change in reflectivity of the phase change material layer; and
determining an alignment of the wafer sensor based on the measured change in reflectivity.

15. The wafer alignment method of claim 13 or 14, further comprising, after the analyzing of the change in the phase change material layer, initializing a measurement history of the wafer sensor by uniformly forming a phase change in the phase change material layer.
